Europäisches Patentamt

European Patent Office

Office européen des brevets

(19)

(11) **EP 1 592 138 A1**

(12) **EUROPÄISCHE PATENTANMELDUNG**

(43) Veröffentlichungstag:
**02.11.2005 Patentblatt 2005/44**

(51) Int Cl.⁷: **H03M 13/37**, H03M 13/29,
H03M 13/45

(21) Anmeldenummer: **04010237.8**

(22) Anmeldetag: **29.04.2004**

(84) Benannte Vertragsstaaten:
**AT BE BG CH CY CZ DE DK EE ES FI FR GB GR HU IE IT LI LU MC NL PL PT RO SE SI SK TR**
Benannte Erstreckungsstaaten:
**AL HR LT LV MK**

(71) Anmelder: **SIEMENS AKTIENGESELLSCHAFT 80333 München (DE)**

(72) Erfinder:
• **Calabro, Stefano, Dr.**
  **81375 München (DE)**
• **Offer, Elke**
  **82205 Munich (DE)**

Bemerkungen:
Amended claims in accordance with Rule 86 (2) EPC.

(54) **Verfahren und Anordnung zur Vorwärtsfehlerkorrektur bei hohen Datenraten**

(57)  Durch serielle Verkettung eines äußeren Reed-Solomon-Codes (RS) und eines inneren (n-1)/n-Tüchler-Faltungscodes (CC unter Verwendung eines Interleavers (3)) wird eine effektive Fehlerkorrektur erreicht. Eine Decodieranordnung in Pipelinestruktur, die für den Faltungscode Decodierung in der dualen Domäne durchführt, ermöglicht die Anwendung dieses Codierverfahrens auch bei extrem hohen Datenraten, wobei eine iterative Decodierung einen nahezu optimalen Codierungsgewinn ermöglicht.

FIG 1

EP 1 592 138 A1

**Beschreibung**

Verfahren und Anordnung zur Vorwärtsfehlerkorrektur bei hohen Datenraten

Die Erfindung betrifft ein Verfahren zur Codierung nach dem Oberbegriff des Anspruchs 1 und eine entsprechende Anordnung nach dem Oberbegriff des Anspruchs 15.

Ein besonders effektives Verfahren zur Fehlerkorrektur ist die verkettete Codierung eines äußeren und eines inneren Codes. Durch einen Interleaver, der zwischen einem äußeren Codierer und einem inneren Codierer eingeschaltet ist, erfolgt das Aufbrechen von bestimmten Fehlermustern. Die Effektivität der Codierung kann durch iterative Decodierverfahren weiter verbessert werden.

Zur Anwendung kommen als Komponentencodes häufig Blockcodes, beispielsweise BCH-Codes. Eine Untergruppe bilden hierbei die Reed-Solomon-Codes (RS-Codes), die insbesondere zur Korrektur von Fehlerbursts entwickelt wurden.

Neben den Blockcodes wurden von J. L. Massey und Kohlenberg Faltungscodes (Convolutionel Codes) entwickelt, die sich sowohl für die Korrektur von Random-Fehlern als auch zur Korrektur von Fehlerburst eignen (J. L. Massey, IEEE Transactions on Information Theory, Juli 1965, Seiten 416-422).

Mit zunehmender Integrationsdichte und Arbeitsgeschwindigkeit der zur Verfügung stehenden Bausteine werden auch bei diesen Codes vorteilhafte Decodierverfahren eingesetzt. Insbesondere bietet das Trellis-Decodierverfahren den Vorteil einer "Soft-Decision-Decodierung", die die analogen Signalwerte der empfangenen Bits berücksichtigt. Die Leistungsfähigkeit dieser Codes liegt - vermutlich aufgrund ihrer blockunabhängigen Codierung und der damit verbundenen Adaption an die Fehlerstruktur sowie der "weichen" Decodierung - über der von vergleichbaren Blockcodes.

Bei 1/n - Faltungscodes (Informationsbits/(Informationsbits + Checkbits) ist das Trellis-Decodierverfahren einfach zu implementieren.

In Proc. IEEE, Intern. Conference of Commun., Geneva, Switzerland, May 1993, pp. 1092 - 1097 wurde in einem Beitrag von J. Hagenauer, E.Offer, L.Papke "Improving the Standard Coding System for Deep Space Missions" ein Codierverfahren vorgestellt, das ein mehrdimensionales verkettetes Codierungsverfahren verwendet. Hierbei wird als äußerer Code ein RS-Code mit "hard decision" und als innerer Code ein Faltungscode der Rate 1/n mit "soft decosion" verwendet. Das Verfahren arbeitet mit einer hohen Redundanz und ist für die Übertragung über kritische Verbindungen entwickelt worden, jedoch für die Übertragung bei hohen Datenraten mit geringer Redundanz nicht geeignet.

N. Tüchler und A. Dholakia haben eine Gruppe neuer Faltungscodes mit verbesserter Leistungsfähigkeit bei geringer Redundanz entwickelt: "New rate-(n-1)/n-Convolutional-Codes with optimal Spectrum, IEEE Symposium on Information Theorie ISIT 02, Lausanne, June 2002. Bei Faltungscodes der Rate (n-1)/n ist eine Implementierung der Trellis-Decodierung wesentlich komplexer.

Diese Faltungscodes können aber durch eine als Dual-MAP-Decoding bezeichnete "Dual Decoding Method" vereinfachtdecodiert werden, die in E. Offer, "Decodierung mit Qualitätsinformation bei verketteten Codiersystemen" Doktorarbeit, Technische Universität München, Februar 1996 Fortschritt-Berichte, VDE Verlag, Series 10, No. 443 für Soft-Decision-Decoding beschrieben ist.

Bei der Codierung mit hohen Bitraten treten im wesentlichen zwei Probleme auf. Einmal kann die Bitrate nur in einem geringen Bereich erhöht werden, zum anderen gibt es, insbesondere bei der Decodierung, Zeitprobleme. Ferner muss sich auch der technische Aufwand in Grenzen halten.

Aufgabe der Erfindung ist es daher, ein effektives Codierverfahren für die Übertragung hoher Datenraten und eine hierfür geeignete Anordnung anzugeben, die mit zumutbaren Aufwand eine erhebliche Verbesserung des Codierungsgewinns gegenüber bisherigen Verfahren/Anordnungen bieten.

Diese Aufgabe wird durch die in Anspruch 1 angegebenen Merkmale gelöst. Eine hierzu geeignete Anordnung ist in dem unabhängigen Anspruch 15 angegeben.

Bei dem erfindungsgemäßen Verfahren werden durch die Kombination von "senkrechter" Codierung durch den äußeren Code und "waagerechter" Codierung einer zu übertragenden Datenmatrix werden die Vorteile eines Produkt-Codes erzielt. Dabei werden die neuesten Codier- und Decodierverfahren so kombiniert, dass sich bei vertretbaren Aufwand eine hervorragende Leistungsfähigkeit ergibt.

So werden als äußerer Code ein Reed-Solomon-Code mit einem inneren Faltungscode (Convolutional Code) der Rate (n-1)/n von bester Leistungsfähigkeit seriell verkettet, was insbesondere bei einer iterativen Decodierung vorteilhaft ist. Da für den Reed-Solomon-Decoder die Wahrscheinlichkeiten für eine richtige oder falsche Decodierung mit hoher Sicherheit zu ermitteln sind, kann bei einem weiteren Decodierungsdurchgang dann von sicheren Codeelementen ausgegangen werden. Das Verfahren kann zur Zeit bei der gesicherten Übertragung höchster Datenraten von 10 bis 80 Gbit/s eingesetzt werden. Bei vertretbarem Aufwand hat es eine hervorragende Leistungsfähigkeit.

Der Reed-Solomon-Code (255, 239, 17) wird bereits bei der - Übertragung optischer Daten empfohlen. Entsprechende Codierer und Decodierer können deshalb verwendet werden, ohne dass hierfür eine Neuentwicklung erforderlich ist.

Ein innerer gespreizter Faltungscode ermöglicht zusätzlich eine Korrektur von Fehlerbursts. Nachteilig ist zur Zeit noch der erhöhte Decodieraufwand.

Statt eines gespreizten Codes werden mehrere Faltungscodes verwendet, die von mehreren Codierern generiert und deren Codewörter miteinander verschachtelt werden. Hierbei haben sich rekursive systematische Faltungscodes als besonders vorteilhaft erwiesen, da sie ein für die Verkettung sehr günstiges Codespektrum aufweisen. Die Ausgangssignale der Codierer werden interleaved (miteinander verschachtelt), um Fehlerbursts auf mehrere Codes zu verteilen.

Zur Sicherstellung einer guten Leistungsfähigkeit soll der Faltungscodierer mindestens vier Verzögerungseinheiten mit der Kapazität von jeweils n-1 Bits, im Ausführungsbeispiel ein Byte, umfassen.

Vorteilhafterweise wird ein terminierter Faltungscode verwendet, bei dem die Anfangs- und Endzustände der Speichereinheiten beziehungsweise der codierten Daten bekannt sind (Tailbiting). Dies ist insbesondere bei Trellis-Decodierung vorteilhaft.

Eine parallele (byteweise) Verarbeitung der Daten ist bei den angestrebten Datenraten von 10 Gbit/s und höher vorteilhaft und einer seriellen Verarbeitung vorzuziehen.

Bei einer byteweisen Verarbeitung ist ein 8/9 Faltungscode ein guter Kompromiss zwischen geringer Redundanz und Korrekturfähigkeit.

Entsprechende Faltungscodes weisen ein günstiges Codespektrum auf. Daraus resultiert eine gute Korrekturfähigkeit bei geringer Redundanz.

Die zu codierenden Bytes werden in unterschiedliche Gruppen aufgeteilt, die von unterschiedlichen RS-Codierern parallel codiert werden. Die Ausgangssignale der RS-Codierer werden dann p-byteweise (p≥1) byteweise verschachtelt. Hierdurch ist nicht nur ein paralleles Arbeiten möglich, sondern Burst-Störungen werden auch auf unterschiedliche Codes verteilt, so dass die gesamte Burst-Korrekturfähigkeit vervielfacht wird. Entsprechend der Störcharakteristik des Übertragungskanals sind die Korrekturfähigkeiten der Codes und die Spreizung aufeinander abzustimmen.

Jedem dem Interleaver nachgeschaltetem Faltungscodierer werden mehrere aufeinanderfolgende Bytes zugeordnet, wodurch die Anzahl der Codierer und Decodierer gegenüber einer byteweisen Verarbeitung reduziert wird.

Bei der Anordnung ist insbesondere vorteilhaft, dass Interleaven und Deinterleaven durch gesteuerte Schalter und Multiplexer beziehungsweise Demultiplexer durchgeführt werden.

Beim Decodieren ermöglicht die Pipeline-Struktur mit mehreren zur iterativen Decodierung in Serie geschalteten Decodiereinrichtungen, die jeweils einen Faltungscode-Decoder und einen Reed-Solomon-Decoder sowie Umschalteinrichtungen zwischen den Decodern aufweisen, die erforderlichen hohen Verarbeitungsgeschwindigkeiten.

Der Decodierungsaufwand für den Faltungscode wird durch Anwendung eines Dual-MAP-Algorithmus reduziert. Der verwendete "Sliding-Window Algorithmus" bewirkt eine weitere Reduzierung des Aufwands.

Weitere vorteilhafte Maßnahmen sind in den übrigen Unteransprüchen angegeben.

Die Erfindung wird anhand eines Ausführungsbeispiels näher erläutert.

Es zeigen

Figur 1      ein allgemeines Prinzipschaltbild zur seriell verketteten Codierung,
Figur 2      ein genauer ausgeführtes Prinzipschaltbild zur Realisierung der Erfindung,
Figur 3      ein Prinzipschaltbild zur Codierung,
Figur 4      ein Prinzipschaltbild der Decodierung,
Figur 5      ein Prinzipschaltbild eines Pipeline-Decoders,
Figur 6      ein Realisierungsprinzip des Pipeline-Decoders,
Figur 7      den Ausgang eines RS-Decodierers,
Figur 8      ein Realisierungsbeispiel für einen Convolutional Codierer,
Figur 9      eine Add-Compare-Select-Offset-Einheit eines Dual-MAP-Decoders,
Figur 10     eine Kalkulationseinheit zur Berechnung der Ausgangswerte pro Trellis-Abschnitt,
Figur 11     die Trellis-Darstellung der Decodierung,
Figur 12     das Prinzip einer Sliding-Window-Decodierung und
Figur 13     ein Bitfehlerraten-Diagramm.

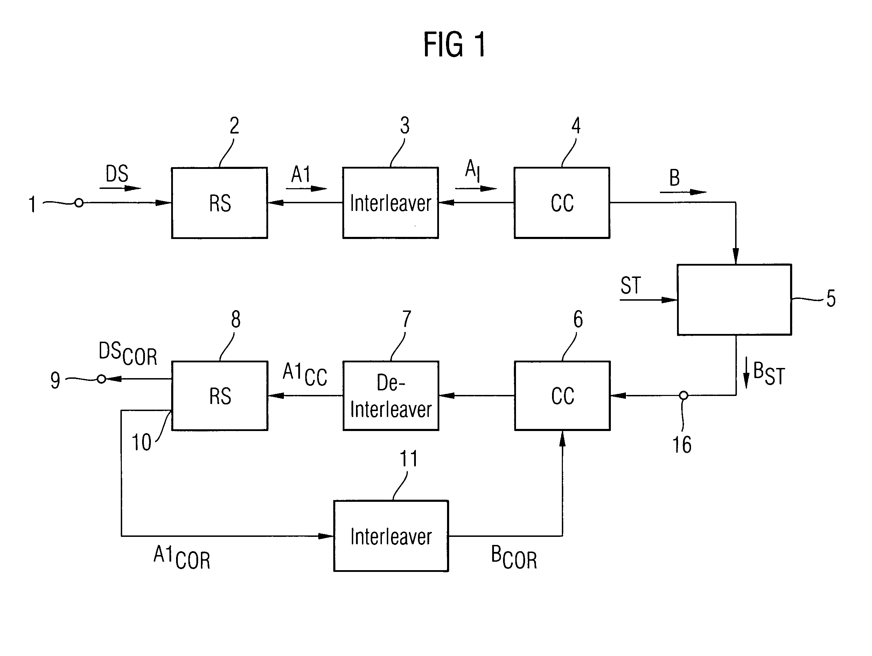

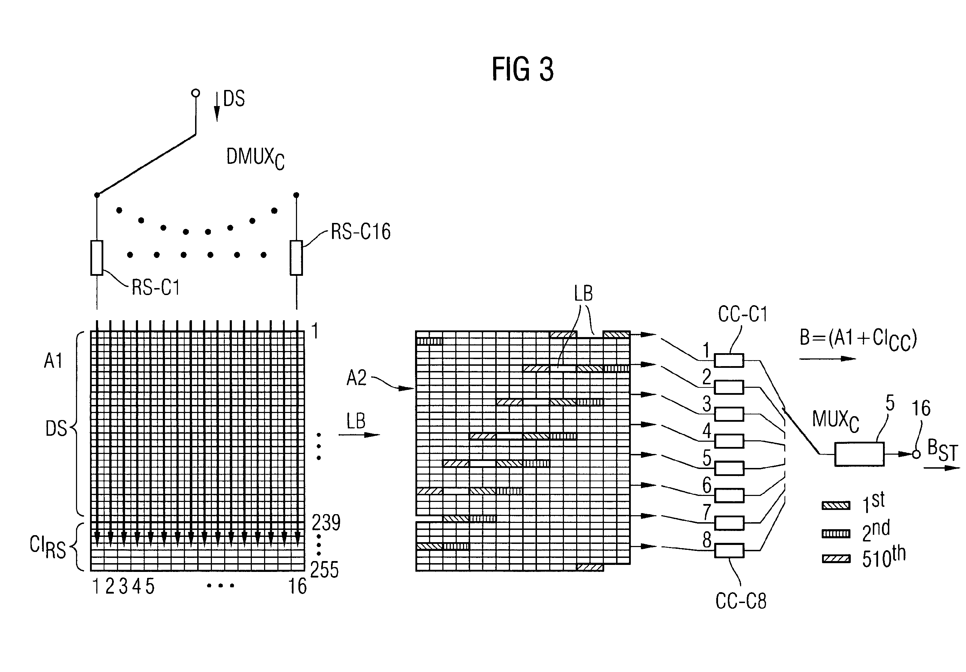

**Figur 1** zeigt das Prinzipschaltbild einer Codieranordnung 2,3,4 zur seriell verketteten Codierung und einer Decodieranordnung 6,7,8,11 zur iterativen Decodierung. Die sendeseitige Codieranordnung 2,3,4 enthält die Reihenschaltung eines äußeren Coders 2, eines Interleavers 3 und eines inneren Coders 4. Dem Eingang 1 des äußeren Coders 2 wird ein Datensignal DS zugeführt. Der Coder 2 ergänzt das Datensignal mit redundanter Kontrollinformation zur Fehlererkennung oder Fehlerkorrektur. Das Ergebnis der Codierung kann vorteilhaft in Form einer ersten Code-Matrix A1 dargestellt werden, die das Datensignal DS und Kontrollinformation $CI_{RS}$ (Figur 3, Checkbytes) enthält. Diese Matrix wird einem Interleaver 3 zugeführt, der die Reihenfolge der Bits oder Bytes ändert und eine "interleaved" Codematrix $A_I$ einem inneren Coder 4 zugeführt. Dieser fügt weitere Checkbits $CI_{CC}$ (Figur 3) hinzu und erzeugt so eine zweite Codematrix B, die in modulierter Form über einen Übertragungskanal 5 zu einer Decodiereinrichtung übertragen wird.

Die übertragenen Daten DS einschließlich der Checkbits werden im Übertragungskanal durch ein Störsignal ST beeinträchtigt, so dass nach der Demodulation des empfangenen Signals am Eingang 16 der Decodiereinrichtung eine empfangene zweite Code-matrix $B_{ST}$ anliegt, bei der mehrere Bits gestört sein können.

Die Decodieranordnung enthält die Reihenschaltung eines inneren Decoders 6, eines Deinterleavers 7 und eines äußeren Decoders 8 und eines weiteren Interleavers 11. Der innere Decoder 6 gibt CC-korrigierte Daten ab, die nach dem Deinterleaven als korrigierte erste Codematrix $AI_{CC}$ dem äußeren Decoder 8 zugeführt werden. Bei der iterativen Decodierung ist außerdem ein weiterer Interleaver 11 vorgesehen, der die am Decoderausgang 10 des äußeren Decoders 8 abgegebene korrigierte erste Codematrix $AI_{COR}$ einschließlich der korrigierten RS-Checkbytes in die korrigierte zweite Matrix $B_{COR}$ umsetzt und erneut dem inneren Decoder 6 (einschließlich CC-Checkbits $CI_{CC}$ oder im inneren Decoder 6 gespeicherter Checkbits) zuführt. Nach mehreren Iterationen wird am Ausgang 9 ein korrigiertes Datensignal $DS_{COR}$ abgegeben.

Bei der Erfindung ist der äußere Coder 2 für einen Block-Code konzipiert, z. B. für einen Reed Solomon Code, und der innere Coder 4 für einen Faltungscode (Convolutional Code CC). Empfangsseitig wird als innerer Decoder ein Dual-MAP-Faltungsdecoder verwendet und für den äußeren Decoder ein herkömmlicher Block-Decoder. Die Funktionen der Interleaver 3 und 11 sowie des Deinterleavers 7 werden durch Multiplexer beziehungsweise Demultiplexer und Speicheradressierung realisiert.

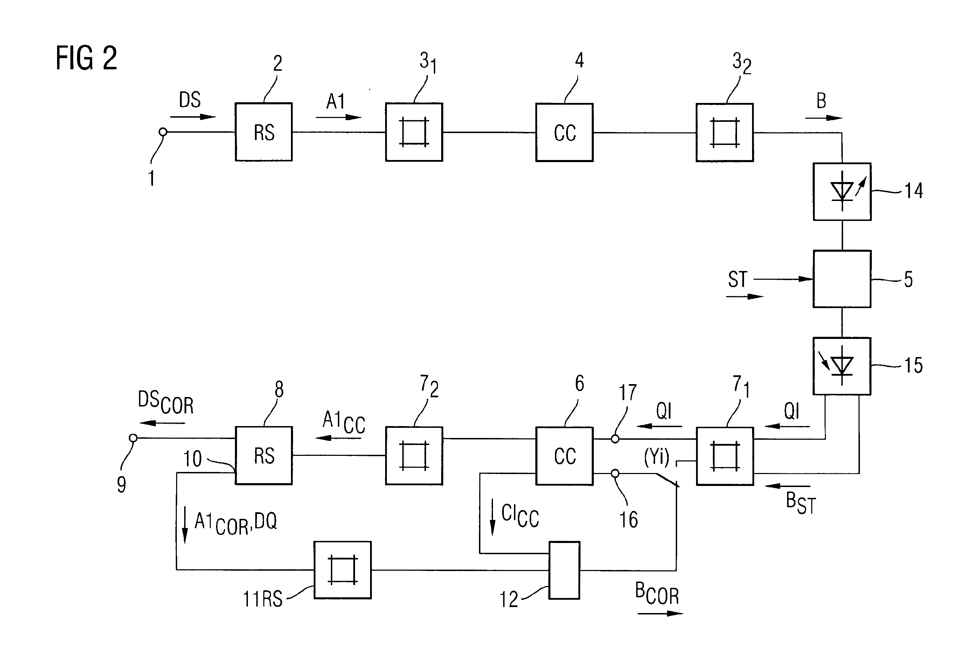

Das erfindungsgemäße Verfahren arbeitet mit einer etwas abgewandelten Struktur. Diese ist in Figur 2 schematisch dargestellt. Zunächst erfolgt die RS-Codierung im äußeren Coder 2. Das Interleaven erfolgt sendeseitig in 2 Stufen durch zwei Teil-Interleaver $3_1$ und $3_2$, zwischen denen der Faltungscodierer 4 angeordnet ist. Die komplett codierten Daten, die Code-matrix B, werden beispielsweise in einem Modulator 14 einem optischen Träger aufmoduliert und übertragen. Für die Übertragung sollte eine möglichst unempfindliche Modulationsart gewählt werden, beispielsweise Phasenmodulation oder Phasendifferenz-Modulation.

Empfangsseitig werden in einem Demodulator 15 die Signalwerte des empfangenen Signal quantisierte Codeelemente (Bits 0, 1) umgesetzt. Da hohe Datenraten verarbeitet werden sollen, arbeiten Codierer und Decodierer byteweise/wortweise.

Die Codeelemente werden folglich zu Symbolen $y_i$ zusammengefasst, die im folgenden als Symbolwörter bezeichnet werden und aus Informationsbits und hier einem Checkbit bestehen, der Decodieranordnung zugeführt. Die Symbolwörter $y_i$ können als Kombination von Vorzeichen, das einer log. 1 oder log. 0 entspricht, und als Qualitätswert QI, der einer der Quantisierungsstufen entspricht, aufgefasst werden. Die Symbolwörter $y_i$ der empfangenen Codematrix $B_{ST}$ werden über den ersten Teil-Deinterleaver $7_1$ dem Dateneingang 16 des inneren Decoders 6 zugeführt.

Entsprechend den sendeseitigen Teil-Interleavern $3_1$ und $3_2$ sind zwei Teil-Deinterleaver $7_1$ und $7_2$ vorhanden. Die decodierten Codeelemente des inneren Decoders 6 werden als "hat" decodierte binäre Codeelemente deinterleaved zur weiteren "hart"-Decodierung dem äußeren RS-Decoder 8 zugeführt, wo sie ebenfalls "hart" decodiert werden. Die am Korrektur-Ausgang 10 des äußeren Decoders 8 ausgegebene korrigierte erste Code-matrix $A1_{COR}$ (Datensignal $DS_{COR}$ einschließlich Checkbits $CI_{RS}$) werden erneut interleaved und von einem Multiplexer 12 um die (korrigierten) Checkbits $CI_{CC}$ des inneren Decoders 6 zur korrigierten Codematrix $B_{COR}$ ergänzt. Dies Signal kann wieder in ein serielles Signal umgesetzt und dem Eingang des Teil-Deinterleavers $7_1$ erneut zugeführt werden. Dieses Vorgehen ist aber weniger zweckmäßig. Vielmehr kann der empfangsseitige Interleaver 11RS vereinfacht ausgeführt werden. Er muss die Funktion des ersten Teil-Deinterleavers $7_1$ nicht mehr realisieren, und die rückgeführten Daten können unter Umgehung des ersten Teil-Deinterleavers $7_1$ direkt über einen Umschalter 13 dem Dateneingang 16 inneren Decoder 6 zugeführt werden (dargestellt). Die Qualitätsinformation QI ist im Teil-Deinterleaver $7_1$ oder im inneren Decoder 6 gespeichert. Dem inneren Decoder steht für einen weiteren Decodiervorgang außerdem eine vom RS-Decoder gelieferte Zuverlässigkeitsinformation zur Verfügung, auf die aber später eingegangen wird.

In **Figur 3** ist der Codiervorgang schematisch dargestellt. Der äußere Coder beinhaltet mehrere parallel arbeitende RS-Codierer RS-C1 bis RS-C16, denen zyklisch jeweils ein Byte des Datensignals DS über einen Demultiplexer $DMUX_C$ zugeführt wird. Die RS-Codierer generieren aus den Datenbytes jeweils ein (255,239,17)-Reed-Solomon-Codewort, wobei die Informationsbits in jeweils den Spalten 1 bis 16, Zeilen 1 bis 239 und die Checkbytes $CI_{RS}$ in den Zeilen 240-255 einer ersten Code-matrix A1 angeordnet werden. Die Bytes des Datensignals DS bilden - in einem Speicher zwischengespeichert - den oberen Teil der ersten 16-spaltigen Codematrix A1 mit 16 Spalten und 255 Zeilen.

Als innerer Code wird ein Faltungscode (Convolutional Code) mit geringer Redundanz verwendet, auf den später noch genauer eingegangen wird. Es handelt sich hierbei um einen Faltungscode mit der Coderate (n-1)/n = 8/9. Um die hohen Datenraten verarbeiten zu können, wird der innere Coder durch 8 parallel arbeitende Faltungscodierer (CC-Codierer) CC-C1 bis CC-C8 ersetzt, die hier zeilenweise die Codematrix verarbeiten. Um alle Bytes der Codematrix auf 8 Faltungscodierer gleichmäßig verteilen zu können, wurden in die Codematrix A1 Leerbytes LB, als unschraffierte Stellen gekennzeichnet, eingefügt, um eine "Lücken" enthaltende Codematrix A2 mit 256 Zeilen zu erzeugen, was eine durch 8 teilbare Zeilenanzahl ergibt.

Die CC-Codierung erfolgt, indem dem ersten bis achten Faltungscodierer jeweils ein Byte oder mehrere Bytes, hier 2 aufeinanderfolgende Bytes, aus jeweils einer Gruppe von insgesamt acht Gruppen mit jeweils 256 in 32 aufeinanderfolgenden Zeilen angeordneten Bytes zugeführt werden. Die von jedem Faltungscodierer jeweils verarbeiteten 2-Byte-Gruppen haben in der Codematrix zueinander einen Abstand von ca. 32 x 16 = 512 Bytes. Dann erfolgt die Codierung der jeweils darauffolgenden 2 Bytes durch den selben Faltungscodierer usw. bis nach dem 510ten ((255 x 16)/8) Codierzyklus sämtliche Bytes codiert sind. Die im ersten, zweiten und 510. Zyklus verarbeiteten Doppelbytes sind durch spezielle Schraffuren gekennzeichnet. Die CC-codierten Bytes gehören unterschiedlichen Spalten und damit unterschiedlichen RS-Codewörtern an, wodurch der Effekt eines ersten Teilinterleavers $3_1$ erzielt wird.

Die Faltungscodierer generieren 9-Bit-Symbolwörter, im folgenden CC- Symbolwörter genannt, die jeweils ein Byte des Datensignals DS oder ein RS-Checkbyte $CI_{RS}$ und ein Checkbit $CI_{cc}$ des Faltungscodes enthalten. Die 9-Bit-Symbolwörter werden dann im zweiten Teil-Interleaver $3_2$, einem Multiplexer $MUX_C$, miteinander verschachtelt (sie bilden die zweite Codematrix B) und anschließend codewortweise oder seriell ausgegeben und übertragen.

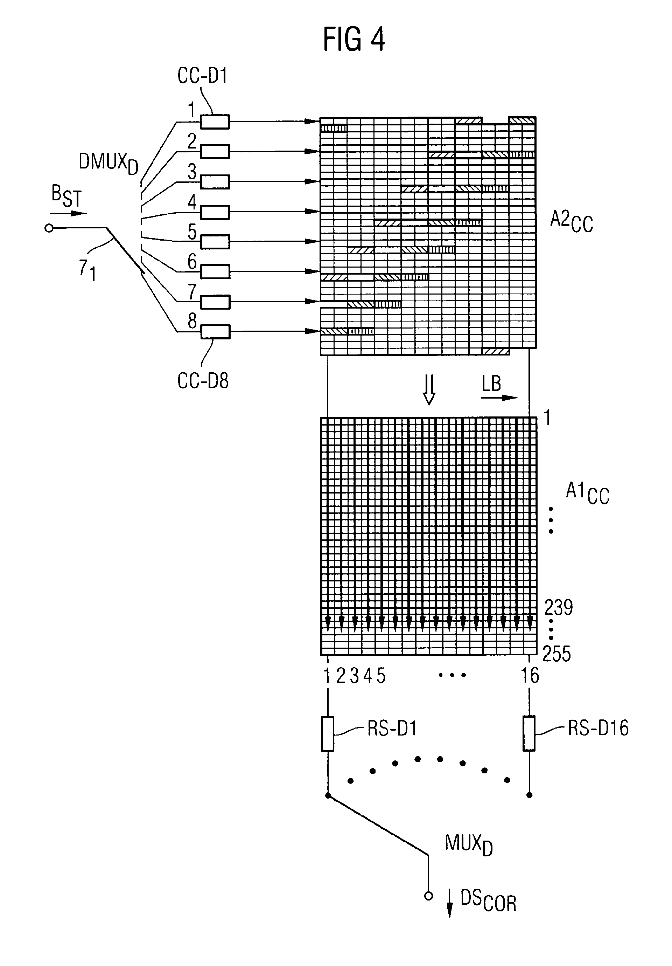

In **Figur 4** ist der Decodiervorgang schematisch dargestellt. Der ankommende Datenstrom, der der Codematrix $B_{ST}$ entspricht, wird durch einen als Teil-Deinterleaver $7_1$ wirkenden Demultiplexer $DMUX_D$ in Gruppen von jeweils 2 CC-Codewörtern umgesetzt, die dann auf 8 Faltungsdecodierer (CC-Decodierer) CC-D1 bis CC-D8 zyklisch verteilt werden. Die Faltungsdecodierer führen eine erste Fehlerkorrektur durch und die korrigierten Bytes werden in einen Speicher eingeschrieben, um so zunächst eine korrigierte Codematrix $A2_{CC}$ oder gleich die Codematrix $AI_{CC}$ zu erzeugen, die, von nicht korrigierten Fehlern abgesehen, mit der ersten Codematrix A1 identisch ist. Deren Spalten werden dann von 16 RS-Decodierern RS-D1 bis RS-D16 parallel decodiert. Durch Multiplexen der ausgegebenen Codewörter im Multiplexer $MUX_D$ wird das korrigierte Datensignal $DS_{COR}$ erzeugt.

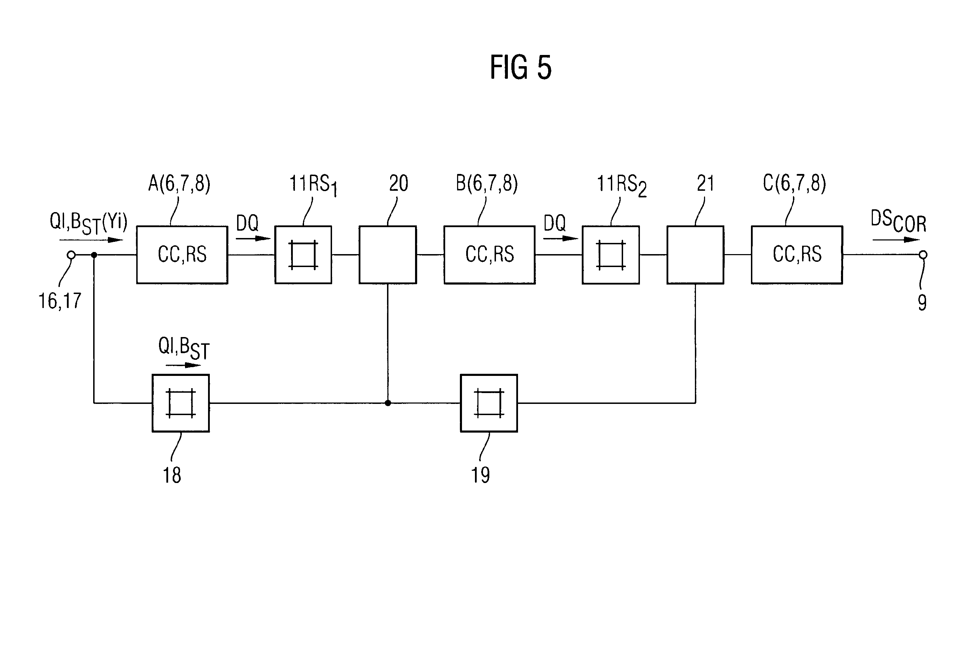

Trotz der parallel arbeitenden Decodierer muss für Datenraten von beispielsweise 40 Gbit/s bei iterativer Decodierung auf eine Rückführung der korrigierten Daten verzichtet werden. Eine realisierbare Decodieranordnung ist deshalb, wie in Figur 5 für drei Decodierdurchgänge dargestellt, in Pipeline-Struktur aufgebaut. Mehrere der in Figur 2 bzw. Figur 4 dargestellten Decodiereinrichtungen A(6,7,8); B(6,7,8) und C(6,7,8) mit jeweils einem inneren Decoder 6 einem Interleaver 7 und einem äußeren Decoder 8 sind in Reihe geschaltet (Pipeline-Anordnung), um eine iterative Fehlerkorrektur durchzuführen. Die empfangene Matrix $B_{ST}$ und die Qualitätsinformation QI werden der ersten Decodiereinrichtung A(6,7,8) zugeführt, die eine erste korrigierte Codematrix abgibt. Zwischen den Decodiereinrichtungen außerdem sind Interleaver $11RS_1$ und $11RS_2$ Umschalt-/Speichereinrichtungen 20 bzw. 21 eingefügt. Über FIFO-Speicher 18 und 19 werden die Qualitätswerte QI oder die bei der RS-Decodierung gewonnenen Zuverlässigkeitswerte DQ den CC-Decodern der zweiten und der dritten Decodiereinrichtung über zugeführt. Die zweite Decodiereinrichtung und der zweite Interleaver $11RS_2$ erzeugen nach dem zweiten Decodierdurchgang eine zweite korrigierte Codematrix $B_{COR2}$ und nach dem dritten Decodierdurchgang wird das korrigierte Datensignal $DS_{COR}$ ausgegeben.

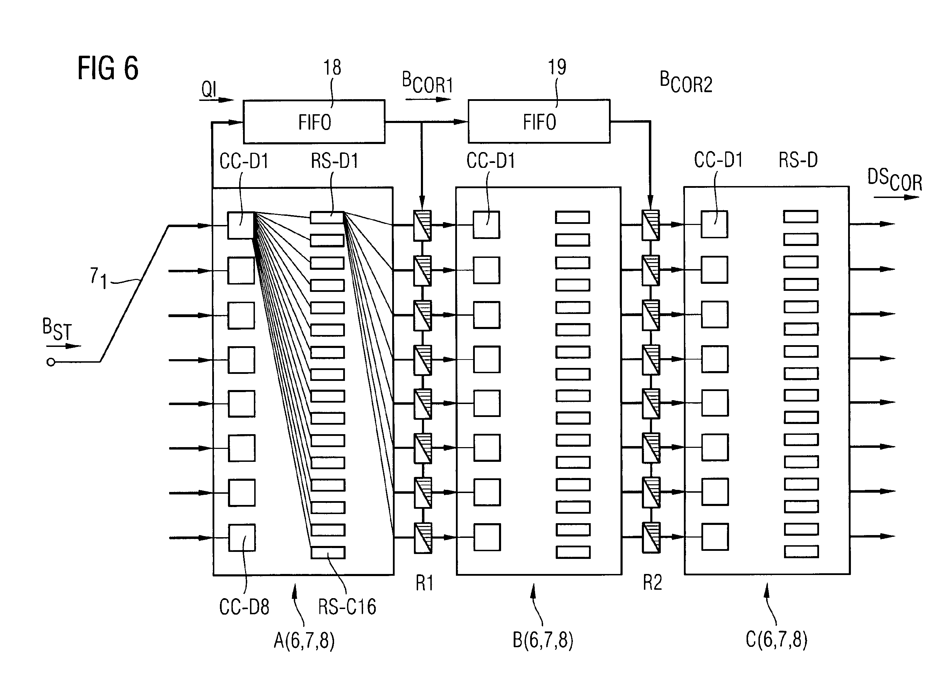

**Figur 6** zeigt die hardwaremäßige Realisierung dieser Decodieranordnung. Jede Decodiereinrichtungen A (6,7,8), B(6,7,8), C(6,7,8) beinhaltet acht Faltungsdecodierer CC-D1 bis CC-D8 und 16 RS-Decodierer RS-C1 bis RS-C16. Die empfangenen Symbolwörter $y_i$ der Codematrix $B_{ST}$ werden durch den ersten Teil-Deinterleaver (Demultiplexer) $7_1$ auf die Eingänge der Faltungsdecodierer CC-D1 bis CC-D8 der ersten Decodiereinrichtung A(6,7,8) verteilt. Vom Ausgang eines Faltungsdecodierers werden die erstmals CC-korrigierten Bytes dann (entspricht dem Interleaver $7_2$) auf die Eingänge aller 16 RS-Decodierer entsprechend der ersten Matrix A1 verteilt. Nach einer vollständigen CC- und RS-Decodierung der empfangenen Codematrix $B_{ST}$ werden die korrigierten Bytes einschließlich Zuverlässigkeitswerten von den Ausgängen jedes RS-Decodierers oder Qualitätswerten QI auf die Eingänge sämtlicher Faltungsdecodierer CC-D der nächsten Decodiereinrichtung B(6,7,8) verteilt, die einen weiteren Decodierdurchgang mit der korrigierten Codematrix $B_{COR1}$ durchführt und die Codematrix $B_{COR2}$ erzeugt. Nach einem weiteren Decodierdurchgang wird am parallelen Datenausgang 9 der für drei Decodierdurchgänge ausgeführten Decodier-Anordnung das korrigierte Datensignal $DS_{COR}$ abgegeben. Die Qualitätswerte QI bzw. die quantisierten Symbolwörter $y_i$ werden über FIFO-Speicher 18 und 19 auch der zweiten und dritten Decodiereinrichtung zur Verfügung gestellt. Hier werden Qualitäts- oder Zuverlässigkeitswerte über als Register R1 bzw. R2 ausgeführte Speicher-/Umschaltelemente 20, 21 den nachgeschalteten Decodiereinrichtung zugeführt.

Auf die Reed-Solomon-Codierung braucht hier nicht weiter eingegangen werden, da sie ausreichend bekannt und beispielsweise in "Kanalcodierung", M. Bossert, Teubner Verlag, 1998 ausführlich beschrieben ist. Der RS-Decoder kann, wie bereits erwähnt, mit großer Wahrscheinlichkeit unterscheiden, ob die von ihm decodierten Symbolwörter richtig oder falsch sind. Für eine mit Sicherheit richtige Entscheidung werden hohe Zuverlässigkeitswerte BQ, beispielsweise ± 40 für ein "1- bzw. 0-Bit" angenommen. Sinkt dagegen die Wahrscheinlichkeit, dass ein "1- oder 0-Bit" korrekt ist (eine vollständige RS-Decodierung kann nicht durchgeführt werden), werden statt der Zuverlässigkeitswerte DQ die Werte der Qualitätsinformation QI/quantisierten Signalwerte des Demodulators weitergegeben. Hierbei hat sich eine auf 3 Bits beschränkte Quantifizierung als ausreichend erwiesen.

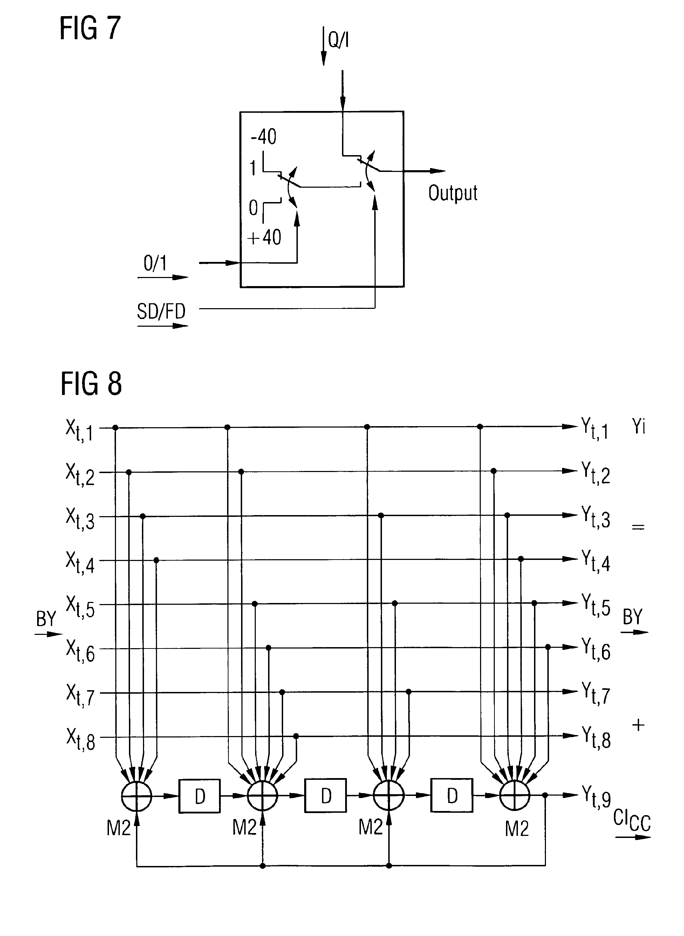

**Figur 7** zeigt wesentliche Elemente der Speicher-/Umschaltelemente (20, 21 in Figur 5) zur Ausgabe der Zuverlässigkeitswerte oder Qualitätswerte, die jedem der RS-Decodierer-Ausgänge nachgeschaltet ist. Bei einer erfolgreichen, sicheren Decodierung SD (successful decoding) wird je nach dem logischen Zustand eines jeden Bits ein Zuverlässigkeitswert DQ = -40 oder +40 über den ersten Umschalter an den nachfolgenden CC-Decodierer ausgegeben. Der RS-Decodierer liefert die Zuverlässigkeitswerte jeweils für ein komplettes Symbolwort. Bei einem vermuteten Decodierfehler FD (failure decoding, dargestellte Schalterstellung) wird über den zweiten Umschalter statt des Zuverlässigkeitswertes DQ der in den FIFOs gespeicherte kleinere QI-Wert (bzw. das quantisierte Symbolwort $y_i$) ausgegeben. Diese Anordnung wird schaltungsmäßig realisiert, indem bei erfolgreicher RS-Decodierung die kleineren Qualitätswerte QI mit den größeren Zuverlässigkeitswerten DQ überschrieben werden. Die Zuverlässigkeitswerte und Qualitätswerte stehen bei der iterativen Decodierung zur Verfügung und verbessern das Ergebnis beim nächsten Decodierprozess der Faltungsdecodierer erheblich.

Als besonders vorteilhaft unter den Faltungscodes hat sich eine Gruppe rekursiver systematischer 8/9-Codes erwiesen, deren Codierer-Prinzip in **Figur 8** dargestellt ist. Der als Beispiel dargestellte Faltungscode hat die Parity-Check-Matrix:

$$H(D) = [1+D+D^2+D^3 \quad 1+D^2+D^3 \quad 1+D+D^3 \quad 1+D^3 \quad 1+D+D^2 \quad 1+D^2 \quad D+D^2 \quad D^2 \quad 1+D+D^2+D^3]$$

Die Schaltung enthält drei als Ring geschaltete Kippstufen D (m = 2), deren Eingängen Modulo-2-Addierer M2 vorgeschaltet sind. Von den Codierereingängen $x_{t,1}$ - $x_{t,8}$ wird den Kippstufen über die Modulo-2-Addierern unterschiedliche Bits eines Datenbytes BY zugeführt.

Die einzelnen Terme der Parity-Check-Matrix geben die Verbindungen der einzelnen Codierereingänge/Bits, angefangen beim Codierereingang/Bit $x_{t,1}$, zu den Modulo-2-Addierern M2 an. Diese Angabe erfolgt mit Hilfe von üblichen Verzögerungsoperanden 1, $D^1$, $D^2$, $D^3$, die auf die Ausgangsseite bezogen sind. Für $x_{t,1}$ mit dem zugeordneten ersten Term $1+D+D^2+D^3$ heißt dies, dass dieses Bit gleichzeitig nach 0, 1, 2, 3 Verzögerungsgliedern allen Modulo-2-Addierern zugeführt wird und hier zur Codierung der Checkbits $CI_{cc}$ beiträgt, die am Codiererausgang $y_{t,9}$ ausgegeben werden. Die Datenbits werden hier unverändert an den Ausgängen $y_{t,1}$ - $y_{t,8}$ ausgegeben. Datenbyte BY und Checkbit $CI_{cc}$ werden zusammen als Symbol oder hier als Symbolwort $b_i$ bezeichnet (und das entsprechende aber quantisierte Symbolwort auf der Empfangsseite mit $y_i$).

Die Parity-Check-Matrizen weiterer geeigneter Codes sind:

Tabelle 1

| Rate | m | $g_0$ (D), $g_1$(D) , ... $g_{n-1}$(D) | $d_f$ | $a_{df}$, $a_{df+1}$ | $C_{df}$, $C_{df+1}$ |
|------|---|----------------------------------------|-------|----------------------|----------------------|
| 8/9 | 2 | 7,7,5,3,2,7,5,3,2 | 2 | 6,60 | 10,168 |
| 8/9 | 3 | 17,17,15,13,11,7,5,6,2 | 2 | 1,35 | 1,98 |
| 8/9 | 4 | 17, 37, 35, 33, 31, 27, 25, 23, 21 | 3 | 1,142 | 1,496 |
| 8/9 | 5 | 65,77,75,73,63,51,45,41, 56 | 4 | 55,812 | 192,3612 |
| 8/9 | 6 | 141,173,167,153,147,135, 125,111,43 | 4 | 19,407 | 65,1811 |

Diese Gruppe von (n-1)/n - Codes wird hier zukünftig als Tüchler-Faltungscodes bezeichnet.

In der Tabelle sind die Generatorpolynome in oktaler Schreibweise angegeben. Z. B. 35 entspricht 11101 mit den Koeffizienten $g_4$ =1; $g_3$ = 1; $g_2$ = 1; $g_1$ =0; $g_0$ = 1. In der Schreibweise mit Verzögerungsoperanden entspricht z. B. $15 = 1 + D + D^2 + D^3 = 1 + 2^1 + 2^2 + 2^3$. Ferner bedeuten: $d_f$ = free distance im Trellis; $a_{df} a_{df+1}$ = Anzahl von Detours mit Hamminggewicht $d_f$ bzw. $d_f$+1 im Trellis;

$C_{df} C_{df}$+1 = Anzahl der Pfade mit Hamminggewicht $d_f$ bzw. $d_f$+1 im Trellis,

m = Anzahl der Speicherelemente.

In Kombination mit Reed-Solomon-Codes erweisen sich Faltungscodes als besonders günstig, die mindestens 3 Speicherelemente, besser 4 Speicherelemente, aufweisen, weil eine gewisse Korrekturfähigkeit des inneren Codes für eine erfolgreiche Durchführung der iterativen Decodierung notwendig ist. Es hat sich gezeigt, dass die Mindestgedächtnislänge von m = 3 erforderlich ist.

Die Decodierung des Faltungscodes erfolgt mit Hilfe des Dual-MAP Verfahrens, das auf den sogenannten dualen Codewörtern basiert, die orthogonal zu allen verwendeten Codewörtern sind. (Bossert, Kanalcodierung,Teubner Verlag, Stuttgart 1998, Seiten 23, 24). Zur Decodierung in der dualen Domäne haben Hartman und Rudolph in "An optimum symbol-by-symbol decoding rule for linear codes" IEEE Trans. on Information Theory, vol. IT-22, pp. 514 - 517, Sept. 1976 für die MAP-Decodierung (maximum a posteriori)einen grundlegenden Beitrag geliefert. Dieses Prinzip wurde für die soft in / soft out - Decodierung von J. Hagenauer, E. Offer, L. Papke "Iterative decoding of binary block and convolutional codes" IEEE Trans. on Information Theory, vol. IT-42, pp. 429 - 445, March 1996 erweitert.

Tabelle 2

| Codewörter | duale Codewörter |
|---|---|
| $C_0, C_1, C_2, C_3$ | $C_0^1, C_1^1, C_2^1, C_3^1$ |
| 0000 | 0000 |
| 1001 | 1111 |
| 0101 | |
| 0011 | |
| 1100 | |
| 1010 | |
| 0110 | |
| 1111 | |

Die Decodierung erfolgt beispielsweise nach dem Bahl-Algorithmus in der dualen Domäne. Ein Dual-MAP Decoder verarbeitet die quantisierten Signalwerte bzw. die Qualitätsinformation, die er aus dem empfangenen Signal ableitet, und gibt neben der harten Entscheidung ebenfalls Zuverlässigkeitswerte für diese Entscheidung ab. Es werden hier jedoch nur die harten Entscheidungen für den RS-Decoder weiterverwendet.

Für die sogenannte "soft in/soft out"-Decodierung wird eine Implementierung im Trellis-Diagramm des dualen Codes gewählt. Für Codes geringer Redundanz stellt dies ein sehr effizientes Verfahren dar, da der duale Code nur wenige Codewörter aufweist.

Für einen Faltungscode mit einem Gedächtnis von m = 3 und einer Coderate von 8/9 umfasst ein Trellis, das alle Codewörter darstellt, $2^3 = 8$ Zustände mit jeweils $2^8 = 128$ Pfaden für jeden Zustand. Das entsprechende Trellis des Dualcodes mit einem Gedächtnis von m = 3 und einer Coderate von 1/9 umfasst bei ebenfalls $2^3 = 8$ Zuständen nur noch zwei Pfade für jeden Zustand. Damit wird die Anzahl der Pfade von insgesamt 8 x 128 = 1016 pro Trellis-Abschnitt auf $8 \times 2 = 16$ Pfade pro Trellis-Abschnitt reduziert. Die Operationen, die im Dual-MAP-Algorithmus durchgeführt werden müssen, lassen sich entsprechend dem Bahl-Algorithmus ebenfalls in dem sogenannten "Sum-Produkt-Prinzip" implementieren. Die Komplexität ist daher äquivalent zu der des Bahl-Algorithmus, nur mit dem Vorteil, dass der Dual-MAP-Algorithmus mit einem einfacheren Trellis arbeitet.

Die Zustandswerte A im Trellis des dualen Codes können bei der Anwendung des Dual-MAP-Algorithmus positive und negative Werte annehmen und werden daher als logarithmierter Betragswert mit dazugehörigen Vorzeichen gespeichert. Die Berechnung der Zustandswerte in der Vorwärtsrekursion bzw. der Rückwärtsrekursion erfolgt beim Dual-MAP-Algorithmus im logarithmischen Bereich zwangsläufig getrennt für Betrag und Vorzeichen.

Als Anhang wird ein Kapitel aus einem Bericht eines der Erfinder beigefügt, der die duale Codierung insbesondere bei binärer Phasenmodulation beschreibt.

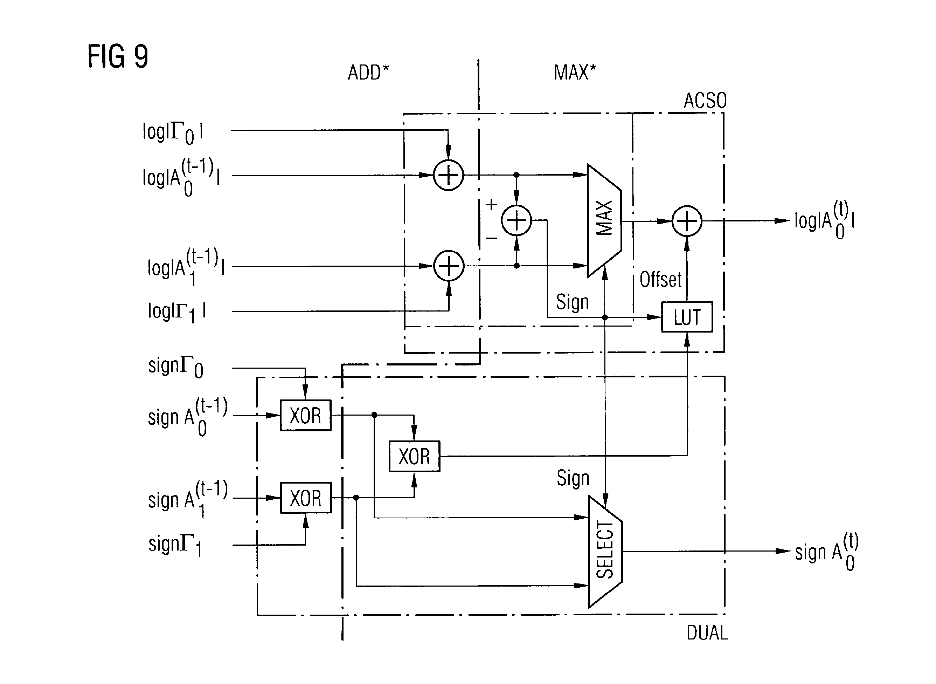

Eine effiziente Realisierung einer Add-Compare-Select-Einheit ist in **Figur 9** dargestellt. Die Berechnung des neuen Zustandswertes $(\log|A_0^{(t)}|, signA_0^{(t)})$ aus den alten Zustandswerten $(\log|A_0^{(t-1)}|, \operatorname{sign} A_0^{(t-1)})$ und $(\log|A_1^{(t-1)}|, \operatorname{sign} A_1^{(t-1)})$ und den zugehörigen Pfadübergangswerten $(\log|\Gamma_0|, \operatorname{sign} \Gamma_0)$ und $(\log|\Gamma_1|, \operatorname{sign} \Gamma_1)$ stellt eine einfache Erweiterung einer aus der Implementierung des Bahl-Algorithmus bekannten Add-Compare-Select-Offset-Einheit (ACSO) dar, die in dem Beitrag "VLSI Architectures for the MAP Algorithmen" in "Appeared in IEEE Transaction on Communications", Vol.51, No. 2, pp. 175 - 185, February 2003 beschrieben ist. Das Design eines entsprechenden VLSI-Bausteins wird durch die Erweiterung der bereits bekannten Architektur erleichtert.

Eine Korrektureinheit LUT, die als Korrekturtabelle ausgeführt ist, liefert Korrekturwerte, die die Berechnung genauer Zustandswerte $\log|A_0^{(t)}|$ erleichtern.

Die Realisierung des DUAL-MAP-Algorithmus erfolgt ausschließlich im logarithmischen Bereich. Die Rechenoperationen werden daher in den logarithmischen Bereich transformiert. Für eine Multiplikation zweier reeller Zahlen $A, B \in R$ ergibt sich im logarithmischen Bereich

$$A \times B \leftrightarrow (\log |A|, \operatorname{sign} A) \times (\log |B|, \operatorname{sign} B)$$

$$= (\log |A| + \log |B|), \operatorname{sign} A \times \operatorname{sign} B.$$

Für eine Addition zweier reeller Zahlen $A, B \in R$ ergibt sich unter Verwendung des Jacobian Logarithmus

$$A + B \leftrightarrow (\log |A|, \text{signA}) + (\log|B|, \text{signB})$$

$$= (\max (\log|A|, \log|B|)) + \log_e (1 + \text{signA} \times \text{signB} \times$$

$$e^{-||\log|A| - \log|B||}),$$

signA falls (max(log |A|, log |B|) = log |A|; sonst sign B. Die Werte $\log_e (1 + \text{sign A} \times \text{sign B} \times e^{-|\log |A| - \log |B||})$ können in der Korrekturtabelle LUT abgelegt werden.

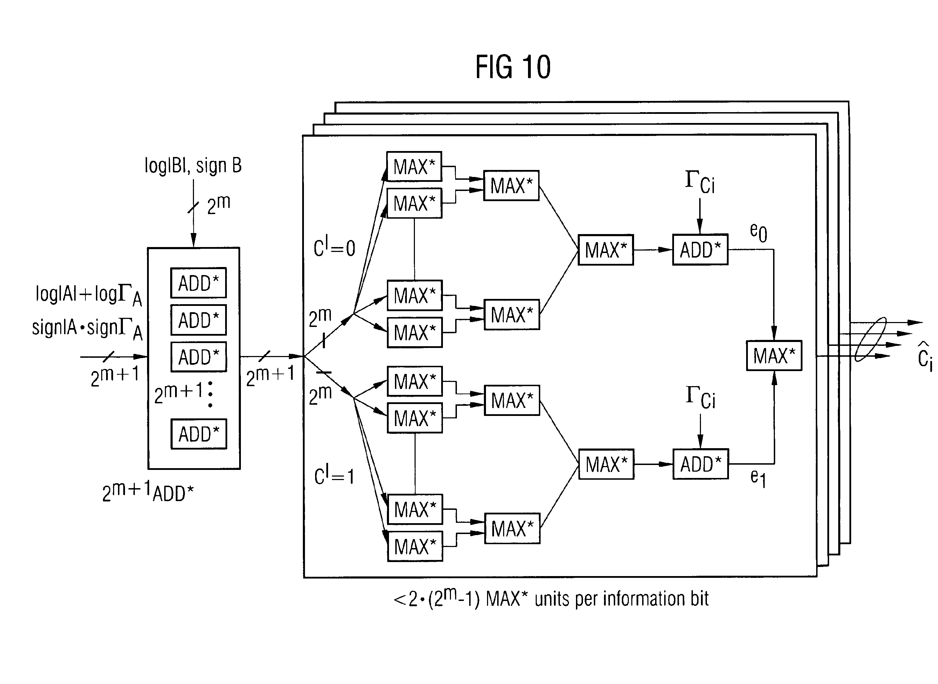

**Figur 10** zeigt eine Kalkulationseinheit zur Berechnung von Entscheidungen pro Trellis-Abschnitt aus den durch Vorwärts- und Rückwärtsrekursion bekannten Trellis-Zuständen, die prinzipiell bekannt ist und deren Funktionsweise nur andeutungsweise erklärt wird. Bei der in Figur 3 angegebenen Codematrix B weist das Trellis eines Faltungscodes $32 \times 16 - 2 = 510$ Trellis-Zustände auf. Und für jedes Informationsbit $c_i$ eines Codewortes pro Trellisabschnitt ist eine eigene Kalkulationseinheit erforderlich. Figur 10 zeigt dies beispielsweise für vier parallel arbeitende Kalkulationseinheiten.

Der linke Block stellt schematisch $2^{m+1}$ ADD*-Einheiten dar, von denen jede mit einem ersten Teil ADD* der in Figur 9 dargestellten Teil Einheit identisch ist. Für jeden der $2^{m+1}$ (m = Anzahl der Speicherzellen) Pfade in einem Trellis-Abschnitt existiert genau eine ADD*-Einheit.

Den ADD*-Einheiten werden von einer nicht dargestellten Vorwärts-Rekursionseinheit RA zu einem Behandlungszeitpunkt im Trellis die Zustandswerte der Vorwärtsrekursion $(\log|\Gamma_0|+\log|A_0|, \text{sign}\Gamma_0, \text{signA}_0)$, $(\log|\Gamma_1|+\log|A_1|, \text{sign}\Gamma_1, \text{signA}_1)$, wobei die Indizes unterschiedliche Zustandswerte und die zugehörigen Pfadübergangswerte kennzeichnen. Da in der dualen Domäne gerechnet wird, sind nur jeweils zwei Pfade vorhanden.

Von einer ebenfalls nicht dargestellten Rückwärts-Rekursionseinheit werden die Zustandswerte der Rückwärtsrekursion: log|B| und signB zugeführt.

Die Pfadübergangswerte $\Gamma_0$, $\Gamma_1$ werden aus den vom Demodulator ausgegebenen Signalwerten und den Kanaleigenschaften (channel value) berechnet.

Die $2^{m+1}$ Ergebnisse aus den ADD*-Einheiten werden im nächsten Schritt in zwei Gruppen aufgeteilt und einer ersten Spalte von MAX*-Blöcken einer Kalkulationseinheit zugeführt. Die erste Gruppe beinhaltet alle Pfade, die dadurch gekennzeichnet sind, dass das zugehörige Codesymbol "$c^{\perp} = 0$" ist; die zweite Gruppe ist durch "$c^{\perp} = 1$" gekennzeichnet.

In jedem der Blöcke MAX*, die dem rechten Teil der in Figur 9 dargestellten Einheit entsprechen, wird aus den an jeweils zwei Eingängen anliegenden Werten der Maximalwert ausgesucht und mit dazugehörigem Vorzeichen ausgegeben. Dieses wiederholt sich in den nächsten beiden Spalten. Die MAX*-Blöcke suchen daher die größte Pfadmetrik mit einem dualen Codesymbol $c^{\perp} = 0$ bzw. $c^{\perp} = 1$. Vor der endgültigen Entscheidung wird der dem aktuellen Bit zugehörige modifizierte Signalwert $\Gamma c_i$ zur Ermittlung von Entscheidungswerten $e_0$ und $e_1$ berücksichtigt. Statt der Ausgabe von Wahrscheinlichkeitswerten für die decodierten Bits entscheidet sich hier der Decoder hart zwischen den zwei Codesymbolen $c^{\perp} = 0$, falls das ermittelte Entscheidungskriterium $e_0 \geq e_1$, und für $c^{\perp} = 1$, falls $e_0 < e_1$ und gibt diese als decodierte Codesymbole (Bits) $c_i$ aus. Der nachfolgende RS-Docoder führt eine Hard-Decision-Decodierung aus und verarbeitet daher nur solche Symbole.

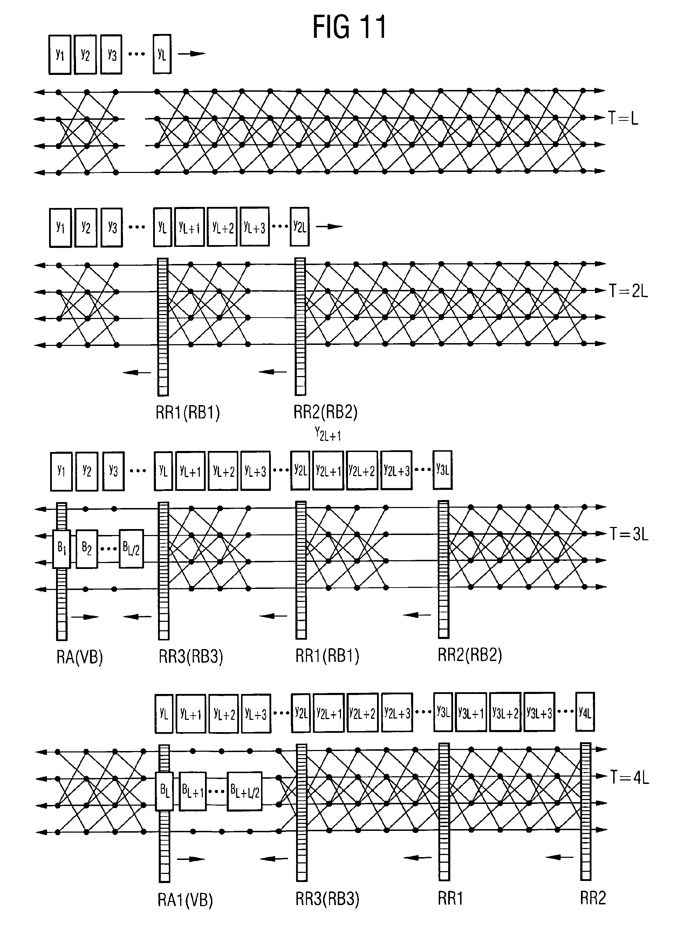

Da pro Trellis-Abschnitt oder dualem Symbolwort $y_1$, $y_2$, ... (Fig. 11) mehrere Informationsbits $c_i$ decodiert werden, beispielsweise 8 Informationsbits bei einem verwendeten 8/9 Code, muss, wie bereits erwähnt, für jedes Informationsbit eine eigene Berechnung erfolgen. Diese erfolgt durch die parallelgeschalteten Kalkulationseinheiten.

Die Arbeitsweise wird in der folgenden Tabelle nochmals dargestellt.

$n_A$ = Anzahl der notwendigen Bits zum Abspeichern von log|A|, $n_A+1$ = Anzahl der notwendigen Bits zum Abspeichern von log|A| und signA.

Tabelle 3

| A, B $\in$ R | | logarithmische Domäne |
|---|---|---|
| A $\leftrightarrow$ ($n_A$+1) Bits | Absolutwert | log\|A\| $\leftrightarrow$ nA Bits |
| | Sign | signA $\leftrightarrow$ 1Bit |
| AxB | Absolutwert | log\|A\| + log\|B\| |
| | Sign | signA x signB |
| A+B | Absolutwert | max(log\|A\|, log\|B\|) +$\log_e$ (1+signAsignBe$^{-|\log|A|-\log|B||}$) |
| | Sign | if max(log\|A\|, log\|B\|) = log\|A\|$\rightarrow$sign A else max (log\|A\|, log\|B\|) = log\|B\|$\rightarrow$sign B |

**Figur 11** zeigt das Trellis bei einer "Sliding Window" Dual-Map-Decodierung bei einem m = 2 Speicherstufen aufweisenden CC-Decodierer. Die beiden mittleren waageechten Führungslinien sind nicht Bestandteil des Trellis.

Die horizontale Zeitachse zeigt das Trellis und die Decodiervorgänge für Zeitabschnitte L bis 4L (L = Anzahl von empfangenen Codewörtern), wobei der Zeitraum zwischen $y_1$ und $y_2$, ... jeweils eine Periode zum Empfang eines Symbolwortes ist und L die sogenannte Verfolgungslänge ist, in der L Codewörter empfangen werden.

Nach einer Zeit L sind $y_L$ Symbol-Wörter (im Ausführungsbeispiel im Gegensatz zur Darstellung jeweils 8 Informationsbits und ein Paritätsbit) empfangen worden und eine Rekursion zur Bestimmung von empfangenen Bits hat noch nicht begonnen.

Erst nachdem L + L/2 Symbol-Wörter y empfangen wurden, wird eine erste Rückwärts-Rekursion RR1 in einer (nicht dargestellten) ersten Rückwärts-Rekursion-Baugruppe RB1 gestartet. Da die Anfangs- und Endwerte der auszuwertenden Trellis-Periode nicht bekannt sind, werden L Symbol-Wörter benötigt, um zu einer zuverlässigen Aussage zu kommen.

Nach 2L empfangenen Symbolwörtern wird eine zweite Rückwärts-Rekursion RR2 in einer Baugruppe B2 gestartet. Die erste Rückwärts-Rekursion RR1 läuft noch und hat das Symbolwort $y_L$ erreicht.

Zum Zeitpunkt 2L + L/2 hat die erste Rückwärtsrekursion L Symbol-Wörter verarbeitet und Ergebnisse erzielt. Die ermittelten Zustandswerte (Symbol-Wörter) werden als Start-Wort für eine dritte Rückwärts-Rekursion RR3 gewählt und die ermittelten Zustandswerte der dritten Rückwärts-Rekursion RR3 werden für spätere Berechnungen gespeichert. Zu dem Zeitpunkt 2L + L/2 wird auch die Baugruppe B1 mit einer erneuten Rückwärts-Rekursion RR1 wieder gestartet.

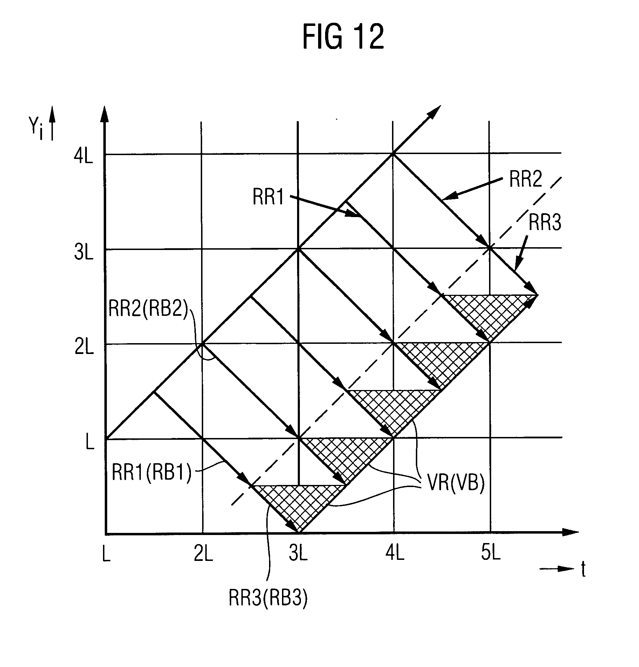

Zum Zeitpunkt 3L erreicht die dritte Rückwärts-Rekursion RR3 den Beginn des Trellis. Zu diesem Zeitpunkt wird die einzige Vorwärts-Rekursion VR in einer VR-Baugruppe VB mit den von der dritten Rückwärts-Rekursion ermittelten Zustandswerten als Anfangswerte gestartet. Die von dieser Vorwärtskorrektur ermittelten Zustandswerte (state values) und die gespeicherten Zustandswerte y der dritten Rückwärts-Rekursion RR3 werden verwendet, um die Ausgangswerte des Dual-Map-Decoders zu ermitteln. Die dritte Rückwärtsrekursion RR3 wird beendet und mit den Zustandswerten der zweiten Rückwärtsrekursion RR2 wird eine neue Rückwärtsrekursion in der RR-Baugruppe RB3 gestartet. Diese Aufgabenteilung zwischen den Rekursionsbaugruppen macht die "Sliding-Window-Decodierung" möglich, wie anhand von Figur 12 näher erläutert wird.

**Figur 12** zeigt den vorstehend beschriebenen Sliding-Window-Decodierprozess in einem Diagramm. Die horizontale Achse präsentiert die Zeit, die x = y - Achse repräsentiert die empfangenen Symbolwörter $Y_i$. Die vertikale Achse repräsentiert die in den Rekursionsbaugruppen verarbeiteten Symbolwörter. Die unter 45° nach oben gerichtete Achse präsentiert die in der Vorwärts-Rekursionsbaugruppen VB verarbeiteten Symbolwörter $Y_i$, die diagonalen Pfeile mit 45° Neigung nach rechts unten präsentieren die in den entsprechenden Rückwärts-Rekursionseinheiten RB1 - RB3 der Rückwärts-Rekursionseinheiten RB1 - RB3 verarbeiteten Symbol-Wörter. Der grau schraffierte Bereich gibt die Zustandsvektoren an, die zwischengespeichert werden müssen.

Wie bereits beschrieben, beginnt die erste Rückwärts-Rekursion RR1 nach dem Zeitpunkt 1,5L in der Baugruppe RB1. Nach 2L beginnt die zweite Rückwärts-Rekursion RR2 in der weiteren RR-Baugruppe RB2. Beide RR-Baugruppen arbeiten gleichzeitig. Zum Zeitpunkt 2,5L muss erneut mit einer weiteren Rückwärts-Rekursion begonnen werden (Dies könnte beispielsweise durch eine dritte RR-Baugruppe erfolgen). Hier werden die Ergebnisse der RR-Rekursionen der RB-Baugruppen RB1 und RB2 von der dritten Rekursionsbaugruppe übernommen und weitergeführt. Dies hat den Vorteil, dass die Berechnung der Codesymbole von der selben RR-Baugruppe und der VR-Baugruppe durchgeführt wird. Während der Vorwärtsrekursion wird die Ausgabe der decodierten Bits (einschließlich Checkbits des äußeren Codes) vorgenommen. Daher kennzeichnet der Pfeil der Vorwärtsrekursion gleichzeitig den zeitlichen Ablauf der Ausgabe der decodierten Bits.

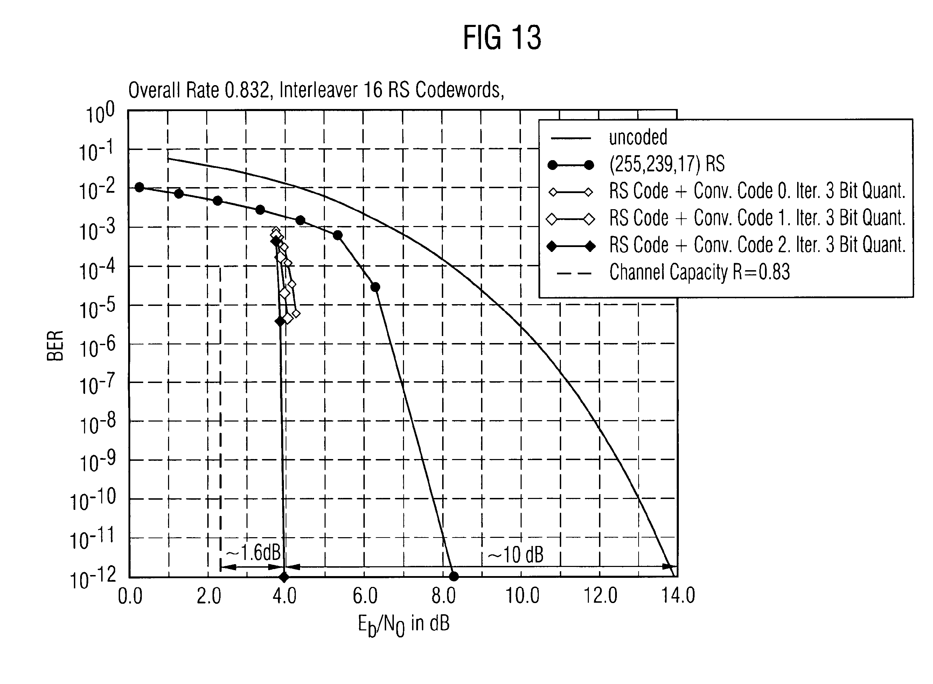

**Figur 13** zeigt Bitfehlerraten BER in Abhängigkeit von Signal-Rausch-Abstand $E_b/N_0$ bei der Verwendung eines (255,239,17)RS-Codes und eines Faltungscodes mit einem Gedächtnis m = 5. Gegenüber der uncodierten Übertragung ergibt sich bei BER = $10^{-12}$ ein Gewinn von ca. 10 dB. Bereits der dritte Decodierdurchgang ergibt nur noch eine minimale Verbesserung, so dass eine Reihenschaltung von 3 Decodiereinrichtungen im Verhältnis zu den Hardware-Kosten optimal ist und maximal 4 Decodiereinrichtungen ausreichend sind. Ebenfalls ist ein Gedächtnis von m = 5 praktisch immer ausreichend.

Die dargestellten Werte sind bis zu einer Bitfehlerrate von BER = $10^{-6}$ durch Simulation ermittelt worden; die Werte bei BER = $10^{-12}$ resultieren aus einer Extrapolation verifiziert durch theoretische Ableitungen der Leistungsfähigkeit des Gesamtcodes mittels der durch Verkettung erzielten Mindestdistanz. Verglichen mit dem theoretisch niedrigstem Signal-Rausch-Abstand für eine fehlerfreie Datenübertragung, der sogenannten Kanalkapazität, ist das neue Verfahren nur 1,6 dB von dieser theoretischen Grenze entfernt.

Bezugszeichen

| | |
|---|---|
| 1 | Coder-Eingang |
| 2 | äußerer Coder |
| 3 | Interleaver |
| 4 | innerer Coder |
| 2,3,4 | Codierereinrichtung |
| 5 | Übertragungskanal |
| 6 | innerer Decoder |
| 7 | Deinterleaver |
| $7_1$, $7_2$ | Deinterleaver/Umschalteinrichtung |
| 8 | äußerer Decoder |
| 6,7,8 | Decodiereinrichtung |
| 9 | Datenausgang |
| 10 | Korrekturausgang |
| 11 | empfangsseitiger Interleaver |
| 11RS | vereinfachter empfangsseitiger Interleave: Umschalteinrichtung |
| 12 | 1Multiplexer |
| 13 , | Umschalter |
| 14 | Modulator |
| 15 | 15 Demodulator |
| 16 | Eingang des inneren Decoders |
| 17 | QI-Eingang |
| 18, 19 | FIFO-Speicher |
| 20, 21 | |
| DS | Datensignal |
| A1 | erste Codematrix |
| A1$_{COR}$ | korrigierte erste Codematrix |
| A2 | Lücken behaftete Codematrix |
| A$_I$ | interleaved Codematrix |
| B | zweite Codematrix |
| B$_{ST}$ | empfangene zweite Codematrix |
| DS$_{COR}$ | korrigiertes Datensignal |
| B$_{COR}$ | korrigierte zweite Codematrix |
| A2 | Lücken enthaltende A-Codematrix |
| QI | Qualitätsinformation/Qualitätswerte |
| DQ | Zuverlässigkeitsinformation /-wert |
| DMUX$_C$ | Demultiplexer (Coder) |
| MUX$_C$ | Multiplexer (Coder) |
| DMUX$_D$ | Demultiplexer (Decoder) |
| MUX$_D$ | Multiplexer(Decoder) |
| LB | Leerbytes |
| ADD* | Add-Einheit |
| MAX* | MAX*-Einheit |
| $\Gamma_A$ | Pfadübergangswerte |
| $\Gamma_C$ | Signalwert eines Codesymbols |
| VR | Vorwärts-Rekursion |
| RA | VR-Baugruppe |
| RR1, RR2, ... | erste, zweite Rückwärtsrekursion |
| RB1, RB2, ... | erste, zweite RR-Baugruppe |
| CC | Faltungscode (Convolutional Code) |
| CI$_{RS}$ | Checkbytes RS-Code (Kontrollinformation) |
| CI$_{CC}$ | Checkbits CC-Code (Kontrollinformation) |
| A(6,7,8) | erste Decodiereinrichtung |
| B(6,7,8) | zweite Decodiereinrichtung |
| C(6,7,8) | dritte Decodiereinrichtung |

LB          Leerbytes


**Patentansprüche**

1.  Verfahren zur gesicherten Übertragung eines hochbitratigen Datensignals (DS), bei dem

    -   sendeseitig durch Codieren des Datensignals (DS) mit einem äußeren Block-Code eine erste Codematrix (A1) erzeugt wird, deren Spalten jeweils einem Codewort entsprechen,
    -   durch Interleaven und durch Codieren der ersten Codematrix (A1) mit einem inneren Faltungscode (CC) eine zweite Codematrix (B) erzeugt wird, die übertragen wird,
    -   dass empfangsseitig ein empfangenes Signal in ein binäres Signal umgesetzt wird, dessen Bits quantisierte Qualitätsmerkmale (QI) zugeordnet werden,
    -   eine erste innere Soft-Decision-Decodierung mittels des inneren Faltungscodes (CC) durchgeführt wird und durch Deinterleaven eine korrigierte erste Codematrix ($A1_{CC}$) erzeugt wird,
    -   eine Hard-Decision-Decodierung der korrigierten ersten Codematrix ($A1_{CC}$) durch den äußeren Block-Code (RS) durchgeführt wird und eine vollständig korrigierte Codematrix ($A1_{COR}$) erzeugt wird und
    -   dass die korrigierte Codematrix ($A1_{COR}$) in eine korrigierte zweite Codematrix ($B_{COR}$) umgesetzt wird, die einschließlich der zugehörigen Qualitätskriterien (QI) mindestens ein weiteres Mal komplett korrigiert wird, wobei die Korrekturaussagen des Block-Codes bei der iterativen Decodierung genutzt werden

    **dadurch gekennzeichnet,**
    **dass** als innerer Code (CC) mehrere gleiche rekursive systematische (n-1)/n-Tüchler-Faltungscodes (CC) verwendet werden und
    **dass** die Soft-Decision-Decodierung des Tüchler-Faltungscodes (CC) in der dualen Domäne erfolgt.

2.  Verfahren nach Anspruch 1,
    **dadurch gekennzeichnet,**
    **dass** ein terminierter Tüchler-Faltungscodes (CC) verwendet wird.

3.  Verfahren nach Anspruch 2,
    **dadurch gekennzeichnet,**
    **dass** der Tüchler-Faltungscodes (CC) mindestens vier Verzögerungseinheiten umfasst.

4.  Verfahren nach Anspruch 3,
    **dadurch gekennzeichnet,**
    **dass** ein 8/9 Tüchler-Faltungscodes (CC) verwendet wird.

5.  Verfahren nach Anspruch 4,
    **dadurch gekennzeichnet,**
    **dass** ein rekursiver 8/9 Tüchler-Faltungscodes (CC) mit der Generator Matrix [65,77,75,73,63,51,45,41,56] verwendet wird.

6.  Verfahren nach einem der vorhergehenden Ansprüche,
    **dadurch gekennzeichnet,**
    **dass** die Decodierung der Tüchler-Faltungscodes (CC) nach einem Dual-MAP-Algorithmus erfolgt.

7.  Verfahren nach Anspruch 6,
    **dadurch gekennzeichnet,**
    **dass** die Decodierung der Tüchler-Faltungscodes (CC) nach dem Dual-MAP-Algorithmus in der logarithmischen Domäne erfolgt.

8.  Verfahren nach Anspruch 1,
    **dadurch gekennzeichnet,**
    **dass** als innerer Code statt mehrerer gleicher Tüchler-Faltungscodes (CC) ein gespreizter Tüchler-Faltungscodes (CCK) verwendet wird.

9.  Verfahren nach Anspruch 6 oder 7,

**dadurch gekennzeichnet,**
**dass** die Decodierung der Tüchler-Faltungscodes (CC) nach einem Sliding-Window Prinzip erfolgt.

10. Verfahren nach einem der vorhergehenden Ansprüche,
**dadurch gekennzeichnet,**
**dass** als äußerer Code ein Reed-Solomon-Code (RS) verwendet wird.

11. Verfahren nach Anspruch 10,
**dadurch gekennzeichnet,**
**dass** ein (255, 239, 17) Reed-Solomon-Code verwendet wird.

12. Verfahren nach einem der vorhergehenden Ansprüche,
**dadurch gekennzeichnet,**
**dass** sendeseitig wort- bzw. byteweise codiert wird und empfangsseitig wort- bzw. byteweise decodiert wird.

13. Verfahren nach Anspruch 1 oder 2,
**dadurch gekennzeichnet,**
**dass** das Interleaven durch paralleles byteweises Codieren der Elemente der ersten Codematrix (A) durch mehrere parallel arbeitende Faltungscodierer (CC-C1 bis CC-C8) und anschließendes Multiplexen der CC-codierten Symbolwörter (BY + $CI_{CC}$) erfolgt.

14. Verfahren nach Anspruch 13,
**dadurch gekennzeichnet,**
**dass** das Interleaven derart durchgeführt wird, dass maximal jeweils zwei aufeinanderfolgende Bytes der ersten Codematrix (A1) in jeweils einem Faltungscodierer (CC-C1 - CC-C8) codiert werden.

15. Anordnung zur gesicherten Übertragung eines hochbitratigen Datensignals (DS), die sendeseitig die Reihenschaltung eines äußeren Coders (2), eines Interleavers (3) und eines inneren Coders (4) zur verketteten Codierung des Datensignals (DS) aufweist und empfangsseitig die Reihenschaltung eines inneren Decoders (6), eines Deinterleavers (7) und eines äußeren Decoders (8) aufweist sowie einen zweiten Interleaver (11; 11RS) im Rückkopplungsweg zur iterativen Decodierung des empfangenen Datensignals ($B_{ST}$) durch Umkehrung der Codierungsschritte,
**dadurch gekennzeichnet,**
**dass** als äußerer Coder (2) mehrere byteweise arbeitende Reed-Solomon(RS)-Codierer (RS-C1 bis RS-C16) angeordnet sind, dass der innere Coder ein byteweise arbeitender rekurrenter Faltungscoder (3) ist, der einen (n-1)/n-Tüchler-Faltungscodes (CC) erzeugt,
**dass** empfangsseitig ein Qualitätsdetektor (14) angeordnet ist, der den Elementen des empfangenen Signals ($B_{ST}$) quantisierte Qualitätskriterien (QI) zuordnet bzw. diese in quantisierte Codeelemente umsetzt,
**dass** der innere Decoder (6) ein byteweise arbeitender Faltungsdecodierer für Soft-Decision-Decodierung ist und
**dass** in einer ersten Decodiereinrichtung (A(6,7,8)) als äußerer Decoder byteweise parallel arbeitende RS-Decodierer (RS-D1 bis RS-D16) vorgesehen sind, die eine korrigierte Codematrix ($C_{CC,RS}$) erzeugen, und
**dass** ein empfangsseitiger Interleaver (11R) die korrigierte Codematrix ($A_{CC,RS}$) einschließlich Checkbits ($CI_{RS}$, $CI_{CC}$) zusammen mit Qualitätswerten (QI, DQ) zur iterativen Dekodierung mindestens einer weiteren in Pipelinestruktur nachgeschalteten Decodiereinheiten (B(6,7,8; C(6,7,8)) zuführt.

16. Anordnung nach Anspruch 15,
**dadurch gekennzeichnet,**
**dass** als innerer Coder (4) mehrere parallel arbeitende Faltungscodierer (CC-C1 - CC-C8) angeordnet sind, deren codierte Datenabschnitte miteinander verschachtelt und seriell ausgesendet werden.

17. Anordnung nach Anspruch 16,
**dadurch gekennzeichnet,**
**dass** empfangsseitig als innerer Decoder mehrere parallel arbeitende Faltungsdecodierer (CC-D1 - CC-D8) angeordnet sind, deren Ausgangssignale zyklisch jeweils einem der RS-Decodierer (RS1 - RS16) zugeführt werden.

18. Anordnung nach Anspruch 15, 16 oder 17,
**dadurch gekennzeichnet,**
**dass** mehrere Decodiereinrichtungen (A(6,7,8); (B(6,7,8); C(6,7,8)) mit jeweils einer Reihenschaltung von einem CC-Decoder (7), einem Deinterleaver (7), einem RS-Decoder (8) und einem hierzu parallel angeordneten QI-Speicher (15, 16) in Pipelinestruktur realisiert sind.

**19.** Anordnung nach Anspruch 17,
**dadurch gekennzeichnet,**
**dass** als Faltungsdecodierer (CC-D1 - CC-D8) Dual-MAP-Decodierer eingesetzt sind.

**20.** Anordnung nach Anspruch 19,
**dadurch gekennzeichnet,**
**dass** die Deinterleaver (7) durch Umschalteinrichtungen ($7_1$, $7_2$, $7_3$) zwischen CC-Decodierern (CC-D1 - CC-D8) und RS-Decodierern (RS1 - RS16) auf den Decodiereinrichtungen (A(6,7,8); (B(6,7,8); C(6,7,8)) und Interleaver (13, 11R) durch Umschalteinrichtungen ($11RS_1$, $11RS_2$) zwischen den Decodiereinrichtungen (A(6,7,8); (B(6,7,8); C(6,7,8)) realisiert sind.

# FIG 1

EP 1 592 138 A1

FIG 2

# FIG 3

EP 1 592 138 A1

$B = (A1 + CI_{CC})$

$B_{ST}$

# FIG 4

FIG 5

FIG 6

## FIG 7

## FIG 8

FIG 9

FIG 10

# FIG 11

# FIG 12

# FIG 13

Overall Rate 0.832, Interleaver 16 RS Codewords,

BER vs $E_b/N_0$ in dB

Legend:
- —— uncoded
- ●—● (255,239,17) RS
- ◇—◇ RS Code + Conv. Code 0. Iter. 3 Bit Quant.
- ◇—◇ RS Code + Conv. Code 1. Iter. 3 Bit Quant.
- ◆—◆ RS Code + Conv. Code 2. Iter. 3 Bit Quant.
- – – Channel Capacity R=0.83

~1.6dB  ~10 dB

EP 1 592 138 A1

**Europäisches Patentamt**

## EUROPÄISCHER RECHERCHENBERICHT

**Nummer der Anmeldung**

EP 04 01 0237

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| Y | HAGENAUER J ET AL: "Improving the standard coding system for deep space missions" PROCEEDINGS OF THE INTERNATIONAL CONFERENCE ON COMMUNICATIONS (ICC). GENEVA, MAY 23 - 26, 1993, NEW YORK, IEEE, US, Bd. VOL. 3, 23. Mai 1993 (1993-05-23), Seiten 1092-1097, XP010137029 ISBN: 0-7803-0950-2 * Abbildung 1 * * Abbildung 3 * * Abbildung 2 * * Seite 1093, Spalte 2 * * Seite 1094, Spalte 1, Zeile 12 - Zeile 20 * * Seite 1094, Spalte 1, Zeile 1 - Zeile 11 * | 1-14 | H03M13/37 H03M13/29 H03M13/45 |
| A | | 1-20 | |
| | ----- | | |
| Y | ELKE OFFER: "The Dual-Decoding Approach for the Soft-In/Soft-Out Principle" SYMPOSIUM ON THE OCCASION OF THE 60TH BIRTHDAY OF PROF. JOACHIM HAGENAUER, [Online] 11. Oktober 2001 (2001-10-11), XP002307136 TU MUNICH, GERMANY Gefunden im Internet: URL:http://www.lnt.ei.tum.de/mitarbeiter/offer/foliendr.ps.zip> [gefunden am 2004-11-23] * Seite 2 * * Seite 10 * * Seite 19 * * das ganze Dokument * | 1-14 | **RECHERCHIERTE SACHGEBIETE (Int.Cl.7)** H03M |
| A | | 1-20 | |
| | ----- | | |
| | -/-- | | |

Der vorliegende Recherchenbericht wurde für alle Patentansprüche erstellt

| Recherchenort | Abschlußdatum der Recherche | Prüfer |
|---|---|---|
| Den Haag | 30. November 2004 | Rydyger, K |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.........................................................................
& : Mitglied der gleichen Patentfamilie, übereinstimmendes Dokument

EPO FORM 1503 03.82 (P04C03)

**Europäisches Patentamt**

**EUROPÄISCHER RECHERCHENBERICHT**

Nummer der Anmeldung

EP 04 01 0237

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| Y | GRAELL I AMAT A ET AL: "New high-rate convolutional codes for concatenated schemes" ICC 2002. 2002 IEEE INTERNATIONAL CONFERENCE ON COMMUNICATIONS. CONFERENCE PROCEEDINGS. NEW YORK, NY, APRIL 28 - MAY 2, 2002, IEEE INTERNATIONAL CONFERENCE ON COMMUNICATIONS, NEW YORK, NY : IEEE, US, Bd. VOL. 1 OF 5, 28. April 2002 (2002-04-28), Seiten 1661-1666, XP010589769 ISBN: 0-7803-7400-2 * Zusammenfassung * * Seite 1661, Spalte 1, Zeile 1 - Zeile 14 * * Seite 1661, Spalte 2, Zeile 1 - Zeile 5 * * Seite 1662, Spalte 1, Zeile 34 - letzte Zeile * * Seite 1662, Spalte 2, Zeile 21 - letzte Zeile * | 1-14 | |
| A | | 1-20 | RECHERCHIERTE SACHGEBIETE (Int.Cl.7) |
| Y | ----- GRAELL I AMAT A ET AL: "A NEW APPROACH TO THE CONSTRUCTION OF HIGH-RATE CONVOLUTIONAL CODES" IEEE COMMUNICATIONS LETTERS, IEEE SERVICE CENTER, PISCATAWAY,US, US, Bd. 5, Nr. 11, November 2001 (2001-11), Seiten 453-455, XP001077408 ISSN: 1089-7798 * das ganze Dokument * * Seite 455, Spalte 2, Zeile 7 - Zeile 15 * * Abbildung 2 * | 1-14 | |
| A | | 1-20 | |
| | ----- -/-- | | |

Der vorliegende Recherchenbericht wurde für alle Patentansprüche erstellt

| Recherchenort | Abschlußdatum der Recherche | Prüfer |
|---|---|---|
| Den Haag | 30. November 2004 | Rydyger, K |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.............................................................................................
& : Mitglied der gleichen Patentfamilie, übereinstimmendes Dokument

EPO FORM 1503 03.82 (P04C03)

**Europäisches**
**Patentamt**

**EUROPÄISCHER RECHERCHENBERICHT**

Nummer der Anmeldung

EP 04 01 0237

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| Y | ELKE OFFER: "Decodierung mit Qualitätsinformationen bei verketteten Codiersystemen" FORTSCHRITTSBERICHTE VDI, Bd. 10, Nr. 443, Juni 1996 (1996-06), XP002307979 DUESSELDORF * Seite 97 - Seite 103 * * Seite 97, Zeile 25 - Zeile 30 * | 1-14 | |
| A | ----- | 1-20 | |
| A | HAGENAUER J ET AL: "ITERATIVE DECODING OF BINARY BLOCK AND CONVOLUTIONAL CODES" IEEE TRANSACTIONS ON INFORMATION THEORY, IEEE INC. NEW YORK, US, Bd. 42, Nr. 2, März 1996 (1996-03), Seiten 429-445, XP000850507 ISSN: 0018-9448 * Seite 438, Spalte 2, Zeile 22 - Zeile 30 * * Seite 439, Spalte 1, Zeile 1 - Zeile 3 * | 1-20 | |
| | ----- | | RECHERCHIERTE SACHGEBIETE (Int.Cl.7) |
| A | TUCHLER M ET AL: "New rate-(N-1)/N convolutional codes with optimal spectrum" PROCEEDINGS 2002 IEEE INTERNATIONAL SYMPOSIUM ON INFORMATION THEORY. ISIT 02. LAUSANNE, SWITZERLAND, JUNE 30 - JULY 5, 2002, IEEE INTERNATIONAL SYMPOSIUM ON INFORMATION THEORY, NEW YORK, NY : IEEE, US, 30. Juni 2002 (2002-06-30), Seiten 396-396, XP010602107 ISBN: 0-7803-7501-7 * Seite 396, Spalte 1, Zeile 5 - Zeile 10 * * das ganze Dokument * | 1-20 | |
| | ----- | | |
| | -/-- | | |

Der vorliegende Recherchenbericht wurde für alle Patentansprüche erstellt

| Recherchenort | Abschlußdatum der Recherche | Prüfer |
|---|---|---|
| Den Haag | 30. November 2004 | Rydyger, K |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
......................................................................
& : Mitglied der gleichen Patentfamilie, übereinstimmendes Dokument

EPO FORM 1503 03.82 (P04C03)

Europäisches
Patentamt

**EUROPÄISCHER RECHERCHENBERICHT**

Nummer der Anmeldung

EP 04 01 0237

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | RIEDEL S: "Symbol-by-symbol MAP decoding of convolutional codes using reciprocal dual convolutional codes" INFORMATION THEORY. 1997. PROCEEDINGS., 1997 IEEE INTERNATIONAL SYMPOSIUM ON ULM, GERMANY 29 JUNE-4 JULY 1997, NEW YORK, NY, USA,IEEE, US, 29. Juni 1997 (1997-06-29), Seite 226, XP010240279 ISBN: 0-7803-3956-8 * Zusammenfassung * * das ganze Dokument * ----- | 1-20 | |
| A | GRAELL AMAT A ET AL: "High-rate convolutional codes: search, efficient decoding, and applications" ARTICLE, 20. Oktober 2002 (2002-10-20), Seiten 37-40, XP010620577 * Zusammenfassung * * Seite 37, Spalte 1, Zeile 21 - Zeile 28 * * Seite 38, Spalte 1, Zeile 29 - Spalte 2, Zeile 7 * ----- -/-- | 1-20 | |

RECHERCHIERTE SACHGEBIETE (Int.Cl.7)

Der vorliegende Recherchenbericht wurde für alle Patentansprüche erstellt

| Recherchenort | Abschlußdatum der Recherche | Prüfer |
|---|---|---|
| Den Haag | 30. November 2004 | Rydyger, K |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes
   Dokument

EPO FORM 1503 03.82 (P04C03)

**Europäisches Patentamt**

# EUROPÄISCHER RECHERCHENBERICHT

Nummer der Anmeldung

EP 04 01 0237

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | MOERZ M ET AL: "Analog decoding of high rate wlbiting codes using the dual trellis" PROCEEDINGS OF THE 2001 IEEE INTERNATIONAL SYMPOSIUM ON INFORMATION THEORY. ISIT 2001. WASHINGTON, WA, JUNE 24 - JUNE 29, 2001, IEEE INTERNATIONAL SYMPOSIUM ON INFORMATION THEORY, NEW YORK, NY : IEEE, US, 24. Juni 2001 (2001-06-24), Seiten 331-331, XP010552937 ISBN: 0-7803-7123-2 * das ganze Dokument * * Seite 331, Spalte 1, Zeile 1 - letzte Zeile * * Seite 331, Spalte 1, Zeile 6 - Zeile 12 * ----- | 1-20 | |
| A | BERKMANN J: "ON TURBO DECODING OF NONBINARY CODES" IEEE COMMUNICATIONS LETTERS, IEEE SERVICE CENTER, PISCATAWAY,US, US, Bd. 2, Nr. 4, April 1998 (1998-04), Seiten 94-96, XP000752594 ISSN: 1089-7798 * Seite 95, Spalte 1 * ----- | 1-20 | RECHERCHIERTE SACHGEBIETE (Int.Cl.7) |

Der vorliegende Recherchenbericht wurde für alle Patentansprüche erstellt

| Recherchenort | Abschlußdatum der Recherche | Prüfer |
|---|---|---|
| Den Haag | 30. November 2004 | Rydyger, K |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

............................................................................
& : Mitglied der gleichen Patentfamilie, übereinstimmendes Dokument

EPO FORM 1503 03.82 (P04C03)